# EUROPEAN PATENT APPLICATION

(11) **EP 1 744 367 A2**
(43) Date of publication of application: **17.01.2007**
(21) Application number: 06014454.0
(22) Date of filing: 12.07.2006
(51) Int. Cl.: H01L 27/146, G01T 1/24

(54) **Radiation image detector**

(30) Priority: 12.07.2005 JP 2005202837
(71) Applicant: Fuji Photo Film Co., Ltd., Minami-Ashigara-shi, Kanagawa (JP)
(72) Inventor: Imai, Shinji c/o Fuji Photo Film Co.,Ltd., Ashigarakami-gun Kanagawa-ken (JP)
(74) Representative: Klunker . Schmitt-Nilson . Hirsch

(57) **Abstract**

A radiation image detector generates electric charge by irradiation with radiation and records a radiation image. The radiation image detector has an electrode layer (5) including a multiplicity of first linear electrodes (5a) connected to a charge amplifier for detecting the electric charge and a multiplicity of second linear electrodes (5b). In the radiation image detector, a ground pattern (20) is formed in the periphery of the electrode layer (5), and the multiplicity of second linear electrodes (5b) is connected to the ground pattern (20).

## Description

### BACKGROUND OF THE INVENTION

### Field of the Invention

The present invention relates to a radiation image detector for recording a radiation image by irradiation with radiation carrying the radiation image and for reading out an electric signal based on the radiation image.

### Description of the Related Art

Conventionally, various kinds of radiation image detector which generate electric charge (charge) by irradiation with radiation transmitted through subjects, and which record radiation images related to the subjects by storing the electric charge, have been proposed and practically utilized in the medical field or the like.

As an example of the radiation image detector, as described above, a radiation image detector is disclosed in U.S. Patent No. 6, 770, 901. In the radiation image detector disclosed in U.S. Patent No. 6, 770, 901, a first electrode layer, a photoconductive layer for recording, a charge transport layer (an electric charge transport layer), a photoconductive layer for readout and a second electrode layer are superposed one on another in this order. The first electrode layer is a layer which transmits radiation. The photoconductive layer for recording is a layer which generates electric charge by irradiation with the radiation. The charge transport layer is a layer which acts as an insulator against latent image electric charge. However, the charge transport layer acts as a conductor of transport electric charge, of which the polarity is opposite to that of the latent image electric charge. The photoconductive layer for readout is a layer which generates electric charge by irradiation with readout light. The second electrode layer is a layer, in which transparent linear electrodes and light blocking linear electrodes are alternately arranged in parallel. The transparent linear electrodes linearly extend and transmit the readout light. The light blocking linear electrodes linearly extend and block the readout light.

In recording of a radiation image by the radiation image detector, as structured above, first, the radiation image detector is irradiated from the first electrode layer side with radiation transmitted through a subject while a high negative voltage is applied to the first electrode layer. When the radiation image detector is irradiated with radiation, as described above, the radiation is transmitted through the first electrode layer, and the photoconductive layer for recording is irradiated with the radiation. Then, a pair of electric charges (dipole) is generated in a portion of the photoconductive layer for recording, which has been irradiated with the radiation. A positive electric charge in the pair of electric charges moves toward the first electrode layer, which is negatively charged. The positive electric charge bonds with a negative electric charge in the first electrode layer, and disappears. Meanwhile, a negative electric charge in the pair of electric charges, generated as described above, moves toward the second electrode layer, which is positively charged. However, the charge transport layer acts as an insulator against the negative charge, as described above. Therefore, the negative electric charge is stored in a charge storage portion at the interface between the photoconductive layer for recording and the charge transport layer. A radiation image is recorded by storing the negative electric charge in the charge storage portion.

Then, when the radiation image, which has been recorded as described above, is read out from the radiation image detector, first, the radiation image detector is irradiated with readout light from the second electrode layer side. Then, the readout light is transmitted through the transparent linear electrodes in the second electrode layer, and the photoconductive layer for readout is irradiated with the readout light. Accordingly, a pair of electric charges is generated in the photoconductive layer for readout. Then, a positive electric charge in the pair of electric charges, which has been generated in the photoconductive layer for readout, bonds with the negative electric charge stored in the charge storage portion. At the same time, the negative electric charge in the pair of electric charges bonds with the positive electric charge in the transparent linear electrode. Accordingly, an electric current is detected by a charge amplifier connected to the transparent linear electrode. The electric current is converted into a voltage and output as an image signal.

When the radiation image detector as described above is used, for example, in mammography, it is necessary that very accurate radiation images are obtained. Therefore, it is necessary that each of the transparent linear electrodes and each of the light blocking linear electrodes are arranged with a narrow space therebetween in the radiation image detector. Further, it is necessary to connect each terminal of a charge amplifier IC to respective transparent linear electrodes, which are arranged with a narrow space therebetween, as described above. However, the arrangement interval of the terminals of the charge amplifier IC is wider than that of the transparent linear electrodes. Therefore, if all of charge amplifier IC's are arranged next to each other on one side of the multiplicity of transparent linear electrodes, the array of the charge amplifier IC's becomes very long, and it becomes difficult to reduce the size of the radiation image detector. Further, the length of wiring from the transparent linear electrodes to the charge amplifier IC' s becomes long and complex, and that causes a problem in production.

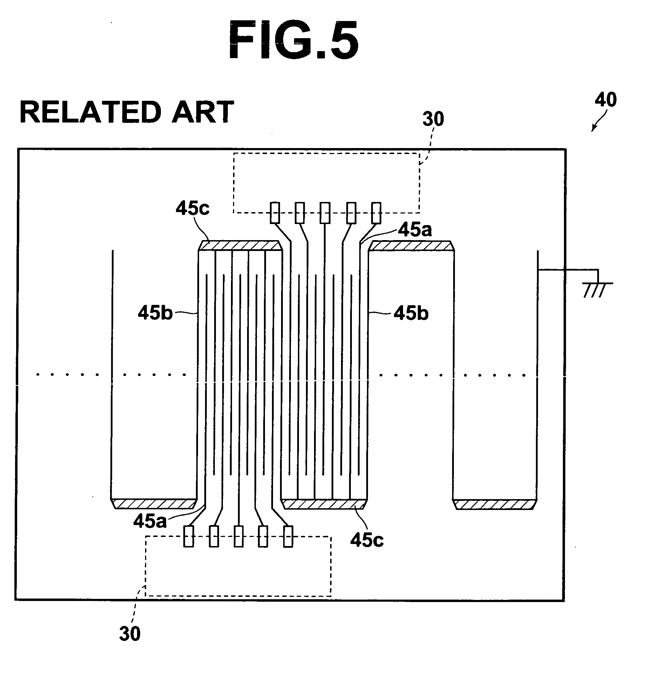

Therefore, as illustrated in Figure 5, each of the charge amplifier IC's 30 may be alternately placed on either side of the transparent linear electrodes 45a, and the transparent linear electrodes 45a may be connected to the charge amplifier IC's 30.

Meanwhile, in the radiation image detector as described above, when an electric current is detected by connecting the transparent linear electrode to the charge amplifier, it is necessary that the light blocking linear electrode is grounded (earthed). Further, it is necessary to connect all of the light blocking linear electrodes to each other so as to supply common ground electric potential (earth electric potential) to all of the light blocking linear electrodes. Therefore, when each of the charge amplifier IC's 30 is alternately arranged on either side of the transparent linear electrodes 45a, as illustrated in Figure 5, a predetermined plurality of light blocking linear electrodes which are adjacent to each other may be connected to each other to form a light blocking linear electrode array 45C. If light blocking linear electrode arrays 45c adjacent to each other are connected to each other, all of the light blocking linear electrodes can be connected to each other.

However, when all of light blocking linear electrodes 45b are connected to each other by using the method, as described above, if a light blocking linear electrode 45b, which is a connecting portion between adjacent light blocking linear electrode arrays 45c, is disconnected due to some reason, many light blocking linear electrodes 45b on one side of the disconnected point are not grounded. Consequently, the image quality of the readout radiation image is affected.

### SUMMARY OF THE INVENTION

In view of the foregoing circumstances, it is an object of the present invention to provide a radiation image detector which can maintain common ground electric potential at linear electrodes other than a disconnected linear electrode even if one of grounded linear electrodes is disconnected.

A radiation image detector according to the present invention is a radiation image detector comprising:
an electric charge generation layer for generating electric charge by irradiation with an electromagnetic wave for recording which carries a radiation image; and
an electrode layer including a multiplicity of first linear electrodes connected to a detection unit for detecting the electric charge generated in the electric charge generation layer as an electric signal and a multiplicity of second linear electrodes which is grounded, wherein each of the multiplicity of first linear electrodes and each of the multiplicity of second linear electrodes are alternately arranged parallel to each other with a predetermined space therebetween, and wherein the electric charge generation layer and the electrode layer are superposed one on the other in this order, and wherein a ground pattern is formed in the periphery of the electrode layer, and wherein the multiplicity of second linear electrodes is connected to the ground pattern.

Further, in the radiation image detector according to the present invention, the ground pattern may be formed so as to surround the multiplicity of first linear electrodes and the multiplicity of second linear electrodes.

Further, an end of each of a plurality of linear electrode arrays, each including a predetermined plurality of second linear electrodes adjacent to each other, may be connected to the ground pattern. When the end of each of the plurality of linear electrode arrays is connected to the ground pattern, the end of each of the plurality of linear electrode arrays, connected to the ground pattern, may be opposite to the end of a linear electrode array adjacent to each of the plurality of linear electrode arrays, connected to the ground pattern.

Further, the detection unit may be a charge amplifier IC (integrated circuit), and the ground pattern may include an amplifier ground portion to which a ground terminal of the charge amplifier IC is connected.

According to a radiation image detector according to the present invention, a ground pattern is formed in the periphery of an electrode layer so as to surround first linear electrodes and second linear electrodes. Further, the second linear electrodes are connected to the ground pattern. Therefore, even if one of the second linear electrodes is disconnected, the other second linear electrodes are grounded through the ground pattern. Hence, it is possible to maintain the common ground electric potential among the second linear electrodes.

Further, since the ground pattern is formed so as to surround the first linear electrodes, it is possible to guard the first linear electrode against external noise. Therefore, it is possible to improve the image quality of a readout radiation image.

### BRIEF DESCRIPTION OF THE DRAWINGS

Figure 1 is a partial sectional view of a radiation image detector in an embodiment of the present invention;
Figure 2 is a plan view of the radiation image detector illustrated in Figure 1;
Figure 3A is a diagram for explaining action for recording a radiation image in the radiation image detector illustrated in Figure 1;
Figure 3B is a diagram for explaining action for recording a radiation image in the radiation image detector illustrated in Figure 1;
Figure 4 is a diagram for explaining action for reading out a radiation image from the radiation image detector illustrated in Figure 1; and
Figure 5 is a diagram illustrating the configuration of a radiation image detector according to the related art.

### DESCRIPTION OF THE PREFERRED EMBODIMENTS

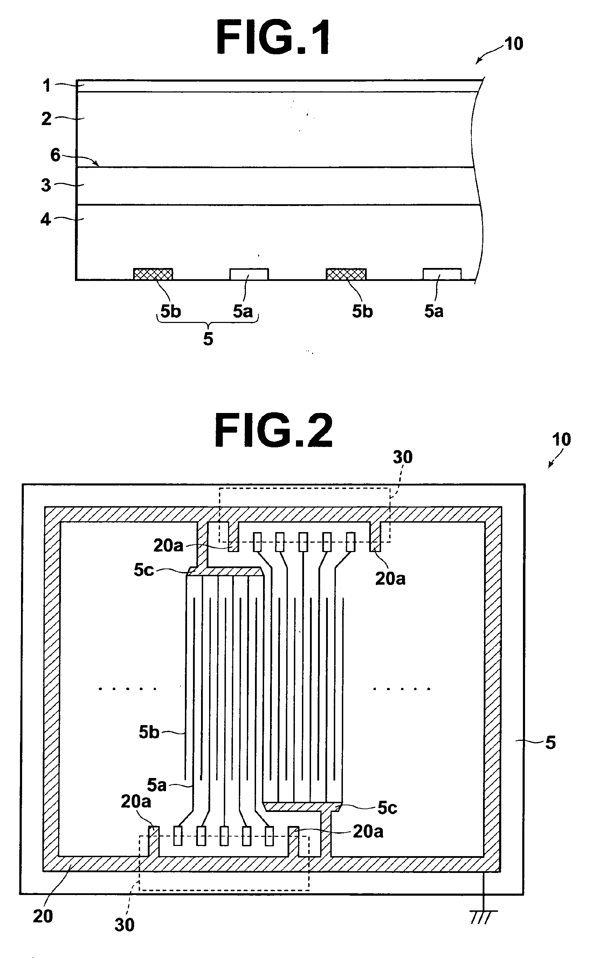

Hereinafter, an embodiment of a radiation image detector according to the present invention will be described with reference to the attached drawings. Figure 1 is a diagram illustrating a partial sectional view of the radiation image detector of the present invention.

In a radiation image detector 10 according to the present invention, a first electrode layer 1, a photoconductive layer 2 for recording, a charge transport layer 3, a photoconductive layer 4 for readout and a second electrode layer 5 are superposed one on another in this order, as illustrated in Figure 1. The first electrode layer 1 transmits radiation which carries a radiation image. The photoconductive layer 2 for recording generates electric charge by irradiation with the radiation transmitted through the first electrode layer 1. The charge transport layer 3 acts as an insulator against electric charge of one of the polarities of the electric charges generated in the photoconductive layer 2 for recording. The charge transport layer 3 also acts as a conductor of electric charge of the opposite polarity. The photoconductive layer 4 for readout generates electric charge by irradiation with readout light. The second electrode layer 5 includes a plurality of first linear electrodes 5a which transmit readout light and a plurality of second linear electrodes 5b which block the readout light. Each of the plurality of second linear electrodes 5b is provided between the plurality of first linear electrodes 5a. Further, a charge storage portion 6 is formed between the photoconductive layer 2 for recording and the charge transport layer 3. The charge storage portion 6 stores electric charge generated in the photoconductive layer 2 for recording. These layers are superposed on a glass substrate sequentially from the second electrode layer 5. However, in Figure 1, the glass substrate is omitted.

As the first electrode layer 1, any kind of material which transmits radiation may be used. For example, a so-called NESA coating (SnO₂), an ITO (Indium Tin Oxide) coating, an IDIXO (Idemitsu Indium X-metal Oxide, manufactured by Idemitsu Kosan Co., Ltd.) coating, which is an amorphous light-transmissive oxide coating, or the like may be used by forming thereinto a layer which has a thickness within the range of 50 to 200nm. Alternatively, coating made of Al, Au or the like which has a thickness of 100nm may be used.

The second electrode layer 5 includes the first linear electrodes 5a and the second linear electrodes 5b, as described above. In the second electrode layer 5, each of the first linear electrodes 5a and each of the second linear electrodes 5b are alternately arranged in parallel with a predetermined space therebetween.

The first linear electrode 5a is made of a conductive material which transmits readout light. Any kind of conductive material which transmits readout light may be used as the material for the first linear electrode 5a. For example, a material, such as ITO or IDIXO, may be used in a manner similar to formation of the first electrode layer 1. Alternatively, metal, such as Al or Cr, may be formed into an electrode which has an appropriate thickness (for example, approximately 10nm) for transmitting readout light.

The second linear electrode 5b is made of a conductive material which blocks readout light. Any kind of conductive material which blocks readout light may be used as the material for the second linear electrode 5b. For example, metal, such as Al or Cr, which blocks the readout light, may be formed into an electrode which has a sufficient thickness for blocking the readout light.

The photoconductive layer 2 for recording should generate electric charge by irradiation with radiation. As the material for the photoconductive layer 2, a material containing a-Se as its main component is used. The a-Se is advantageous in that it has relatively high quantum efficiency for radiation, high dark resistance or the like. An appropriate thickness of the photoconductive layer 2 for recording is approximately 500µm.

As a material for the charge transport layer 3, it is preferable that a difference between the mobility of electric charge charged in the first electrode layer 1 during recording of a radiation image and that of electric charge which has an opposite polarity to that of the electric charge charged in the first electrode layer 1 is as large as possible (for example, more than or equal to 10², and preferably, more than or equal to 10³). As the material for the charge transport layer 3, an organic compound, such as poly-N-vinylcarbazole(PVK), N,N'-diphenyl-N,N'-bis(3-methylphenyl)-[1,1'-biphenyl]-4,4'-diamine (TPD) or a discotic liquid crystal, or a semiconductor, such as a dispersion of TPD in polymer (polycarbonate, polystyrene or PVK) or a-Se doped with 10 to 200ppm of Cl, is appropriate.

As a material for the photoconductive layer 4 for readout, a material which exhibits conductivity by irradiation with readout light or erasing light should be used. For example, a photoconductive material which contains one of a-Se, Se-Te, Se-As-Te, metal-free phthalocyanine, metal phthalocyanine, MgPc (Magnesium phthalocyanine), VoPc (phase II of Vanadyl phthalocyanine) and CuPc (Copper phthalocyanine) as its main component is preferable as the material for the photoconductive layer 4 for readout. Further, an appropriate thickness of the photoconductive layer 4 for readout is within the range of approximately 0.1 to 1µm.

Next, Figure 2 is a plan view of the radiation image detector 10 according to the present invention. In Figure 2, the radiation image detector 10 is viewed from the second electrode layer 5 side.

As illustrated in Figure 2, the radiation image detector 10 includes a ground pattern 20 to which the second linear electrodes 5b is connected. As illustrated in Figure 2, the ground pattern 20 is formed in the periphery of the radiation image detector 10 so as to surround the first linear electrodes 5a and the second linear electrodes 5b. For example, the ground pattern 20 should be made of a material, such as A1 or Cr, in a manner similar to formation of the second linear electrode 5b. In the radiation image detector 10 according to the present invention, the ground pattern 20 has a ring shape. However, it is not necessary that the ground pattern 20 has the ring shape. The shape of the ground pattern 20 may be a shape in which a part of a ring is removed. The shape of the ground pattern 20 may be any shape which is formed in the periphery of the second linear electrodes 5b, and to which all of the second linear electrodes 5b are connected. It is preferable that the ground pattern 20 surrounds all of the first linear electrodes 5a and all of the second linear electrodes 5b so as to reduce external noise entering the first linear electrodes 5a.

In the radiation image detector 10 according to the present invention, an end of each of a plurality of linear electrode arrays 5c, each including a predetermined plurality of second linear electrodes adjacent to each other, is connected to the ground pattern 20. The plurality of linear electrode arrays 5c is connected to the ground pattern 20 so that the end of each of the plurality of linear electrode arrays, connected to the ground pattern 20, is opposite to the end of a linear electrode array adjacent to each of the plurality of linear electrode arrays, connected to the ground pattern 20.

Further, a charge amplifier IC 30 is connected to the first linear electrode 5a so as to detect an electric signal flows into the first linear electrode 5a. Further, an amplifier ground portion 20a, to which a ground terminal of the charge amplifier IC 30 is connected, is formed in the ground pattern 20. In the radiation image detector 10 according to the present invention, a rectangular amplifier ground portion 20a is formed, as illustrated in Figure 2. However, it is not necessary that the shape of the amplifier ground portion 20a is rectangular. A part of the ring-shaped ground pattern 20 may be utilized as the amplifier ground portion 20a.

Next, the action of the radiation image detector according to the present invention will be described.

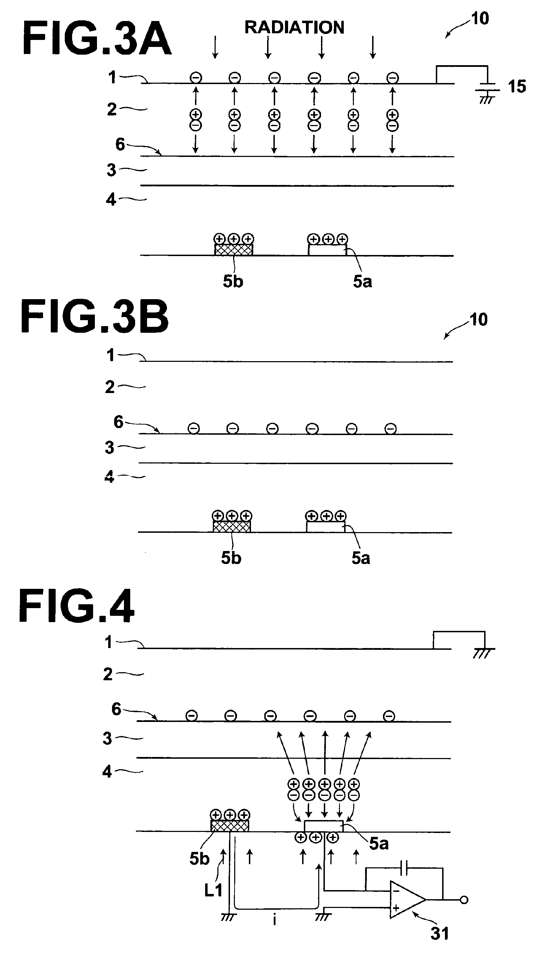

First, as illustrated in Figure 3A, negative voltage is applied to the first electrode layer 1 in the radiation image detector 10 from a high voltage source. In this state, a subject is irradiated with radiation emitted from a radiation source, and the radiation is transmitted through the subject. Accordingly, the radiation image detector 10 is irradiated with radiation carrying a radiation image of the subject from the first electrode layer 1 side of the radiation image detector 10. At this time, both of the first linear electrodes 5a and the second linear electrodes 5b are grounded.

Then, the radiation projected onto the radiation image detector 10 is transmitted through the first electrode layer 1, and the photoconductive layer 2 for recording is irradiated with the radiation. Then, a pair of electric charges is generated in the photoconductive layer 2 for recording by irradiation with the radiation. Then, a positive electric charge in the pair of electric charges bonds with a negative charge charged in the first electrode layer 1, and the positive electric charge disappears. A negative electric charge in the pair of electric charges is stored, as latent image electric charge, in the storage portion 6 formed at the interface between the photoconductive layer 2 for recording and the charge transport layer 3 (please refer to Figure 3B).

Then, as illustrated in Figure 4, the radiation image detector 10 is irradiated with readout light L1 from the second electrode layer 5 side in a state in which the first electrode layer 1 and the second linear electrode 5b are grounded. The readout light L1 is transmitted through the first linear electrode 5a and the photoconductive layer 4 for readout is irradiated with the readout light L1. When the photoconductive layer 4 is irradiated with the readout light L1, a pair of electric charges is generated in the photoconductive layer 4 for readout. Then, a positive charge in the pair of electric charges bonds with latent image electric charge in the storage portion 6. Further, a negative charge in the pair of electric charges bonds with a positive charge charged in the first linear electrode 5a in the second electrode layer 5.

Since the positive electric charge and the negative electric charge bond with each other, as described above, an electric current flows into the first linear electrode 5a and each of charge amplifiers 31 in the charge amplifier IC 30. Then, the electric current is detected as an image signal by obtaining the integral of the electric current. Accordingly, an image signal based on the radiation image is read out.

In the radiation image detector 10 according to the present invention, the ground pattern 20 is formed in the periphery of the second electrode layer 5 so as to surround the first linear electrodes 5a and the second linear electrode 5b. Further, the second linear electrodes 5b are connected to the ground pattern 20. Therefore, even if one of the second linear electrodes 5b is disconnected, the other second linear electrodes 5b are grounded through the ground pattern 20. Therefore, it is possible to maintain common ground electric potential at the second linear electrodes 5b.

Further, since the ground pattern 20 is formed so as to surround the first linear electrodes 5a, it is possible to guard the first linear electrodes against external noise. Therefore, it is possible to improve the image quality of a readout radiation image.

Further, since the amplifier ground portion 20a, to which the ground terminal of the charge amplifier IC 30 is connected, is formed in the ground pattern 20, it is possible to supply stable ground electric potential to the charge amplifiers 31.

Further, in the aforementioned embodiment, the present invention is applied to a radiation image detector which adopts a so-called direct conversion method. The direct conversion method is a method, in which a radiation image is recorded by being irradiated with radiation and by directly converting the radiation into electric charge. However, it is not necessary that the radiation image detector is a radiation image detector adopting the direct conversion method. The present invention may be applied to a radiation image detector which adopts another method, such as a so-called indirect conversion method. The indirect conversion method is a method, in which a radiation image is recorded by temporarily converted radiation into visible light and by converting the visible light into electric charge.

Further, it is not necessary that the layers of the radiation image detector according to the present invention are structured as described in the above embodiment. An additional layer or layers may be added to the layers.

## Claims

1. A radiation image detector comprising:
an electric charge generation layer (2) for generating electric charge by irradiation with an electromagnetic wave for recording which carries a radiation image; and
an electrode layer (5) including a multiplicity of first linear electrodes (5a) connected to a detection unit (30) for detecting the electric charge generated in the electric charge generation layer as an electric signal and a multiplicity of second linear electrodes (5b) which is grounded, wherein each of the multiplicity of first linear electrodes (5a) and each of the multiplicity of second linear electrodes (5b) are alternately arranged parallel to each other with a predetermined space therebetween, and wherein the electric charge generation layer (2) and the electrode layer (5) are superposed one on the other in this order, **characterized in that** a ground pattern (20) is formed in the periphery of the electrode layer (5), and wherein the multiplicity of second linear electrodes (5b) is connected to the ground pattern (20).

2. A radiation image detector, as defined in Claim 1, **characterized in that** the ground pattern (20) is formed so as to surround the multiplicity of first linear electrodes (5a) and the multiplicity of second linear electrodes (5b).

3. A radiation image detector, as defined in Claim 1 or 2, **characterized in that** an end of each of a plurality of linear electrode arrays (5c), each including a predetermined plurality of second linear electrodes (5b) adjacent to each other, is connected to the ground pattern (20), and wherein the end of each of the plurality of linear electrode arrays (5c), connected to the ground pattern (20), is opposite to the end of a linear electrode array (5c) adjacent to each of the plurality of linear electrode arrays, connected to the ground pattern (20).

4. A radiation image detector, as defined in any one of Claims 1 through 3, **characterized in that** the detection unit (30) is a charge amplifier IC (integrated circuit) (30), and wherein the ground pattern (20) includes an amplifier ground portion (20a) to which a ground terminal of the charge amplifier IC (30) is connected.
